# EUROPEAN PATENT APPLICATION

(11) **EP 4 484 854 A1**
(43) Date of publication of application: **01.01.2025**
(21) Application number: 23192193.3
(22) Date of filing: 18.08.2023
(51) Int. Cl.: F25B 9/12, F25B 21/00, F25B 23/00, F25B 25/00, H10N 60/10

(54) **CRYOGENIC COOLING APPARATUS, AND METHOD FOR CRYOGENICALLY COOLING A SAMPLE**

(30) Priority: 27.06.2023 EP 23181685
(71) Applicant: Bluefors Oy, 00370 Helsinki (FI)
(72) Inventor: GUNNARSSON, David, 00370 Helsinki (FI); ROSCHIER, Leif, 00370 Helsinki (FI)
(74) Representative: Papula Oy

(57) **Abstract**

A cryogenic cooling apparatus comprises a vessel (101) configured to hold operating fluid (102) during operation and at least one solid-state microrefrigerator (103) with a heat receiving end and a heat releasing end. The cryogenic cooling apparatus comprises a sample attachment (704) configured to receive a sample (104) into mechanical and thermal connection for cooling said sample during operation of the cryogenic cooling apparatus. Said at least one solid-state microrefrigerator (103) is located on a thermal conduction path between said sample attachment and operating fluid (102) held by said vessel (101), with said heat receiving end towards said sample (104) and said heat releasing end towards said operating fluid (102).

## Description

### FIELD OF THE INVENTION

The invention is generally related to the cooling of samples to temperatures in the millikelvin range. In particular, the invention is related to the structure and operation of cooling devices with which high cooling power may be obtained at low temperatures.

### BACKGROUND OF THE INVENTION

In cryogenic cooling technology, dilution refrigerators are typically used to cool samples to temperatures in the millikelvin range, meaning temperatures from only few millikelvins to some tens of millikelvins. There are other cooling techniques like adiabatic demagnetization refrigerators, but they require the use of magnetic fields, which is often not possible if the sample uses magnetically sensitive components like SQUIDs and/or qubits.

Main parts of a dilution refrigerator are the mixing chamber, the still, and the helium circulation system. The mixing chamber is the coldest part, in which a layer of liquid helium-3 (more accurately: ³He-rich phase or concentrated phase) floats on top of liquid helium mixture (³He-poor phase or diluted phase). The helium circulation system draws mixture from the lower part of the mixing chamber into the still, from which gaseous helium-3 is circulated, through purification and condensing, back into the ³He-rich phase in the mixing chamber. The process of moving helium-3 across the phase boundary in the mixing chamber is endothermic, so when the conditions and helium circulation are appropriate, the mixing chamber cools down to temperatures as low as only some millikelvins. In a cryostat, the mixing chamber is attached to a mechanical structure that constitutes the working region, to which a payload to be cooled is attached. The payload is usually called a sample, and it may involve for example a scientific experiment or one or more quantum processing circuits.

The cooling power of an operating dilution refrigerator scales approximately in the second to fourth power of temperature, i.e. ~T²...T⁴. An unfortunate consequence thereof is that the cooling power becomes significantly lower towards the lowest temperatures. Many applications, like practical quantum computers for example, would benefit from a combination of a high cooling power and a very low achievable temperature. With dilution refrigerators, this requires large volumes of helium-3 and large infrastructure in the form of the helium circulation system; simply increasing the helium circulation rate without other changes in dimensioning would inevitably sacrifice some achievable temperature. Helium-3 is a scarce and extremely valuable resource, which means that increasing the cooling power through increasing the helium-3 volume is a costly solution.

### SUMMARY

It is an objective to present hardware means and methods that may be used to provide high cooling power at low temperatures at reasonable cost and technical complicatedness. Another objective is to present a cryogenic cooling system capable of operating within wide ranges of parameter values in order to find an optimal combination of cooling power, temperature, and cost. A further objective is to present such a cryogenic cooling system and method that are scalable to cryogenic cooling need of various capacities.

These and further advantageous objectives are achieved by utilising a solid-state microrefrigerator between the sample and the coldest part of helium circulation.

According to an embodiment, there is provided a cryogenic cooling apparatus that comprises a vessel configured to hold operating fluid during operation and at least one solid-state microrefrigerator with a heat receiving end and a heat releasing end. The cryogenic cooling apparatus comprises a sample attachment configured to receive a sample into mechanical and thermal connection for cooling said sample during operation of the cryogenic cooling apparatus. Said at least one solid-state microrefrigerator is located on a thermal conduction path between said sample attachment and operating fluid held by said vessel, with said heat receiving end towards said sample and said heat releasing end towards said operating fluid.

According to an embodiment, said vessel comprises a cover part attached to a base part with a sealed attachment. This involves at least the advantage that manufacturing the vessel and assembling it as a part of a cryogenic cooling system is straightforward.

According to an embodiment, at least one of said at least one solid-state microrefrigerators is inside said vessel in a space limited by said cover part and said base part. This involves at least the advantage that efficient transfer of heat from the solid-state microrefrigerator to the operating fluid can be achieved.

According to an embodiment, said base part is an integral entity between said sealed attachment and said sample attachment. This involves at least the advantage that the structure of the base part is simple and robust.

According to an embodiment, said base part comprises at least a first portion of a first material and a second portion of a second, different material, said first and second portions being fixedly attached together. Said first portion may then be involved in said sealed attachment and said second portion may be involved in said sample attachment. This involves at least the advantage that the base part may be accurately tailored to meet various requirements concerning its mechanical and thermal properties.

According to an embodiment, said first portion is of a same material as said cover part and said second material has a higher thermal conductivity at sub-Kelvin temperatures than said first material. This involves at least the advantage that the second portion can conduct heat efficiently as a part of the thermal conduction path for the sample, while the first portion can be made mechanically very well compatible with the cover part.

According to an embodiment, the cryogenic cooling apparatus comprises a thermal interface enhancer attached to the heat releasing end of the solid-state microrefrigerator. This involves at least the advantage that heat can be efficiently transferred from the solid-state microrefrigerator to the operating fluid, and the less efficient thermal couplings between other parts nearby can be bypassed.

According to an embodiment, said thermal interface enhancer comprises thermally conductive material in sintered form. This involves at least the advantage that the thermal interface enhancer can be made in a well-known way, with well-known properties.

According to an embodiment, said thermal interface enhancer comprises an array of thermally conductive posts protruding out of the heat releasing end of the solid-state microrefrigerator. This involves at least the advantage that a number of alternatives are available for manufacturing at least parts of the thermal interface enhancer.

According to an embodiment, among said at least one solid-state microrefrigerators is at least one NIS refrigerator or SINIS refrigerator that comprises, in the following order from said heat receiving end to said heat releasing end, a first contact layer, a layer of normal metal - insulator - superconductor tunnel junctions or superconductor - insulator - normal metal - insulator - superconductor tunnel junctions, and a second contact layer. This involves at least the advantage that efficient cooling at very low temperatures can be achieved with little additional losses.

According to an embodiment, the cryogenic cooling apparatus comprises a dilution refrigerator and said vessel is a mixing chamber of said dilution refrigerator. This involves at least the advantage that a base temperature at the millikelvin range can be offered as a starting point to the solid-state microrefrigerator.

According to a second aspect, there is provided a method for cryogenically cooling a sample. The method comprises providing cooled operating fluid in a vessel, using at least one solid-state microrefrigerator to absorb heat from said sample into a cold end of the solid-state microrefrigerator, and releasing heat from a hot end of said solid-state microrefrigerator towards said operating fluid.

According to an embodiment, said releasing of heat from said hot end of said solid-state microrefrigerator towards said operating fluid comprises releasing said heat from said hot end of said solid-state microrefrigerator directly to said operating fluid. This involves at least the advantage that the heat conduction paths become relatively straightforward and thus efficient.

According to an embodiment, said releasing of heat from said hot end of said solid-state microrefrigerator towards said operating fluid comprises releasing said heat from said hot end of said solid-state microrefrigerator to a cold end of a further solid-state microrefrigerator. This involves at least the advantage that even lower temperatures can be reached than with only a single solid-state microrefrigerator.

According to an embodiment, said providing of cooled operating fluid in a vessel comprises circulating helium mixture into a mixing chamber of a dilution refrigerator, and the method comprises operating said dilution refrigerator at a level that makes a temperature of said mixing chamber to be less than 600 mK but more than 50 mK. This involves at least the advantage that the dilution refrigerator can provide more cooling power than if it had to be operated near its absolute lowest achievable base temperature.

### BRIEF DESCRIPTION OF THE DRAWINGS

The accompanying drawings, which are included to provide a further understanding of the invention and constitute a part of this specification, illustrate embodiments of the invention and together with the description help to explain the principles of the invention. In the drawings:
**Figure 1** illustrates a cryogenic cooling arrangement according to an embodiment,
**figure 2** illustrates a cryogenic cooling arrangement according to an embodiment,
**figure 3** illustrates a cryogenic cooling arrangement according to an embodiment,
**figure 4** illustrates a cryogenic cooling arrangement according to an embodiment,
**figure 5** illustrates a cryogenic cooling arrangement according to an embodiment,
**figure 6** illustrates a cryogenic cooling arrangement according to an embodiment,
**figure 7** illustrates a cryogenic cooling arrangement according to an embodiment,
**figure 8** illustrates a solid-state microrefrigerator in an exploded view,
**figure 9** illustrates a cryogenic cooling arrangement according to an embodiment,
**figure 10** illustrates a detail of a cryogenic cooling arrangement according to an embodiment,
**figure 11** illustrates a detail of a cryogenic cooling arrangement according to an embodiment, and
**figure 12** illustrates a cryogenic cooling arrangement according to an embodiment.

### DETAILED DESCRIPTION

In the following description, reference is made to the accompanying drawings, which form part of the disclosure, and in which are shown, by way of illustration, specific aspects in which the present disclosure may be placed. It is understood that other aspects may be utilised, and structural or logical changes may be made without departing from the scope of the present disclosure. The following detailed description, therefore, is not to be taken in a limiting sense, as the scope of the present disclosure is defined by the appended claims.

For instance, it is understood that a disclosure in connection with a described method may also hold true for a corresponding device or system configured to perform the method and vice versa. For example, if a specific method step is described, a corresponding device may include a unit to perform the described method step, even if such unit is not explicitly described or illustrated in the figures. On the other hand, for example, if a specific apparatus is described based on functional units, a corresponding method may include a step performing the described functionality, even if such step is not explicitly described or illustrated in the figures. Further, it is understood that the features of the various example aspects described herein may be combined with each other, unless specifically noted otherwise.

In an essential role in the following description is a solid-state microrefrigerator. This term refers to a class of devices that transfer heat from a heat receiving end to a heat releasing end in response to the application of electric power from an electrical power supply.

One possible form of a solid-state microrefrigerator is based on the use of electrons in a standard transistor structure as a gas-equivalent refrigerant that is alternately expanded and compressed in a Carnot cycle to induce cooling. Such a solid-state microrefrigerator is known for example from a patent publication US20220208644A1, which is incorporated herein by reference.

Another possible form of a solid-state microrefrigerator is an electrocaloric cooler. Such a solid-state microrefrigerator is known for example from a scientific publication Adriana Greco, Claudia Masselli: "Electrocaloric Cooling: A Review of the Thermodynamic Cycles, Materials, Models, and Devices", Magnetochemis-try 2020, 6, 67; doi:10.3390/magnetochemistry6040067, which is incorporated herein by reference.

Another possible form of a solid-state microrefrigerator is a solid-state microrefrigerator based on normal metal - insulator - superconductor tunnel junctions, superconductor - insulator - normal metal - insulator - superconductor tunnel junctions, or semiconductor - superconductor tunnel junctions. Such solid-state microrefrigerators are frequently referred to as NIS refrigerators, SINIS refrigerators, or Sm-S refrigerators respectively. Examples of NIS refrigerators are known for example from a patent publication US6581387B1, which is incorporated herein by reference. Examples of Sm-S refrigerators are known for example from a scientific publication Emma Mykkänen et al: "Thermionic junction devices utilizing phonon blocking", Sci. Adv. 2020; 6:eaax9191, 10 April 2020, which is incorporated herein by reference.

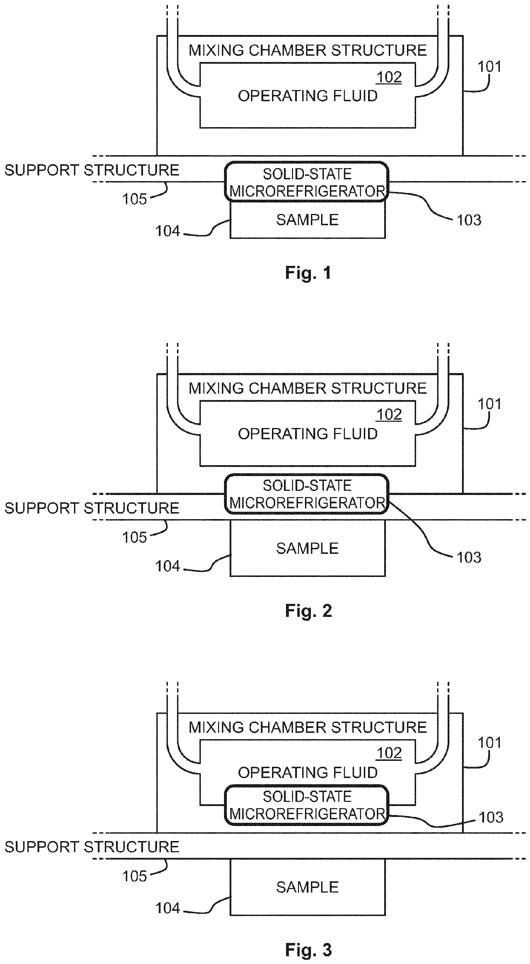

Fig. 1 illustrates schematically some parts of a cryogenic cooling apparatus. It comprises a vessel 101 that is configured to hold operating fluid 102 during operation. As a non-limiting example, the cryogenic cooling apparatus may comprise a dilution refrigerator, in which case the vessel 101 may be a mixing chamber of the dilution refrigerator as reflected by its text label in fig. 1. In such a case, the operating fluid 102 in the vessel 101 would consist of a mixture of helium isotopes helium-3 and helium-4. As another example, the vessel 101 may be a part of a cooling system based on the evaporation of liquid helium, in which case the operating fluid 102 would be liquid helium.

The cryogenic cooling apparatus of fig. 1 comprises at least one solid-stage microrefrigerator 103, which has a heat receiving end (cold end) and a heat releasing end (hot end). When operable, the solid-state microrefrigerator 103 is capable of maintaining a temperature gradient between its cold end and its hot end. It absorbs heat from anything that is thermally coupled to the cold end, transfers the absorbed heat to the hot end, and releases it there to any further body or substance that is thermally coupled to the hot end. In fig. 1 and all subsequent drawings, the cold end of the solid-state microrefrigerator 101 is directed downwards and the hot end is directed upwards.

For graphical simplicity, fig. 1 comprises only one block labeled as a solid-state microrefrigerator 103. In practical embodiments of the principle shown in fig. 1, and also of the principles shown in the subsequent drawings, there may be a plurality of solid-state microrefrigerators in parallel and/or serial configurations. A parallel configuration of two solid-state microrefrigerators has the cold ends of the solid-state microrefrigerators coupled together and the hot ends of the solid-state microrefrigerators coupled together. A serial configuration of two solid-state microrefrigerators has the hot end of one solid-state microrefrigerator coupled to the cold end of another solid-state microrefrigerator.

The cryogenic cooling apparatus of fig. 1 comprises a sample attachment configured to receive a sample 104 into mechanical and thermal connection. The aim is to cool the sample 104 during operation of the cryogenic cooling apparatus. The sample 104 could alternatively be called a payload. The sample 104 may be for example a part of a scientific experiment and/or a quantum processing circuit.

The (at least one) solid-state microrefrigerator 103 is located on a thermal conduction path between the sample attachment and the operating fluid 102 held by the vessel 101. The heat receiving end (cold end) of the solid-state microrefrigerator 103 is towards the sample 104 and the heat releasing end (hot end) of the solid-state microrefrigerator 103 is towards the operating fluid 102. Consequently, the solid-state microrefrigerator 103 is configured to transfer heat from the sample 104 towards the operating fluid 102 during operation. Thus, during operation, the sample 104 can be cooled colder than the operating fluid 102 in the vessel 101.

In fig. 1, the cryogenic cooling apparatus comprises a support structure 105 for providing mechanical support to the vessel 101. The support structure 105 may be for example a flange of a cryostat. Considering its location on the thermal conduction path between the sample attachment and the operating fluid 102 held by the vessel 101, the solid-state microrefrigerator 103 is located between the sample 104 and the support structure 105. The solid-state microrefrigerator 103 may comprise (at least a part of) the sample attachment, so that the sample 104 may be (at least partly) attached to the solid-state microrefrigerator 103. From the viewpoint of mechanical attachment, the solid-state microrefrigerator 103 may be the mechanical element that attaches the sample 104 to the support structure 105. Heat that the cold end of the solid-state microrefrigerator 103 absorbs from the sample 104 will be transferred through the solid-state microrefrigerator 103 and released from its hot end to the support structure 105, from which it will be further conducted to the structure of the vessel 101 and eventually to the operating fluid 102.

Fig. 2 illustrates parts of a cryogenic cooling apparatus that is otherwise similar to that of fig. 1 but the location of the solid-state microrefrigerator 103 on the thermal conduction path between the sample attachment and the operating fluid 102 held by the vessel 101 is slightly different. In fig. 2, the solid-state microrefrigerator 103 is located between the support structure 105 and the vessel 101. Heat from the sample 104 will be conducted to the support structure 105, from which it will be absorbed by the cold end of the solid-state microrefrigerator 103. The absorbed heat will be transferred through the solid-state microrefrigerator 103 and released from its hot end to the structure of the vessel 101, from which it will be conducted to the operating fluid 102.

In the embodiment of fig. 2, the solid-state microrefrigerator 103 may constitute at least a part of the mechanical attachment between the vessel 101 and the support structure 105. It may constitute even the sole mechanical element that attaches the vessel 101 to the support structure 105.

Fig. 3 illustrates parts of a cryogenic cooling apparatus that is otherwise similar to that of figs. 1 and 2 but the location of the solid-state microrefrigerator 103 on the thermal conduction path between the sample attachment and the operating fluid 102 held by the vessel 101 is again slightly different. In fig. 3, the solid-state microrefrigerator 103 is located between the structure of the vessel 101 and the operating fluid 102 held therein. Heat from the sample 104 will be conducted to the support structure 105, from which it will be further conducted to the structure of the vessel 101. The cold end of the solid-state microrefrigerator 103 absorbs heat from the structure of the vessel 101. The absorbed heat will be transferred through the solid-state microrefrigerator 103 and released from its hot end to the operating fluid 102. The embodiment of fig. 3 could be characterized so that the solid-state microrefrigerator 103 enhances the transfer of heat from the solid structure of the vessel 101 to the operating fluid 102 contained therein.

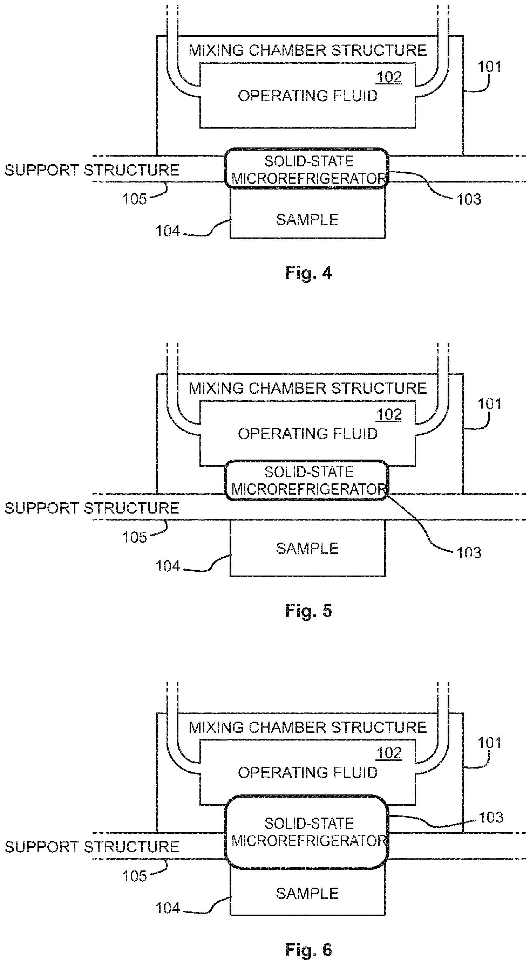

Fig. 4 illustrates parts of a cryogenic cooling apparatus that is otherwise similar to that of figs. 1 to 3 but the location of the solid-state microrefrigerator 103 on the thermal conduction path between the sample attachment and the operating fluid 102 held by the vessel 101 is again slightly different. In fig. 4, the solid-state microrefrigerator 103 is located between the sample 104 and the structure of the vessel 101. Heat from the sample 104 will be absorbed by the cold end of the solid-state microrefrigerator 103, transferred through the solid-state microrefrigerator 103 and released from its hot end to the structure of the vessel 101, from which the heat will be further coupled to the operating fluid 102. In a way, at least considering thermal coupling, the solid-state microrefrigerator 103 bridges the support structure 105 in the embodiment of fig. 4.

It should be noted that the graphical presentation in figs. 1 to 6 is schematic only and should not be construed as teaching any particular mechanical structure. For example, in fig. 4, one possibility is such where the support structure 105 only supports the vessel 101 by its sides or its upper edge, so that the solid-state microrefrigerator 103 could be the one and only thing that mechanically links the sample 104 and the (lower part of the) vessel 101. Also, it is by no means taught that the sample 104 should be below the vessel 101 in all embodiments. The principle shown in fig. 4, for example, could be implemented so that the support structure 105 supported the vessel 101 from below, but the solid-state microrefrigerator 103 would attach the sample 104 to a side and/or top surface of the vessel 101. It is possible, though, that the support structure 105 may offer some direct mechanical support for the solid-state microrefrigerator 103 and/or the sample 104 as well.

Fig. 5 illustrates parts of a cryogenic cooling apparatus that is otherwise similar to that of figs. 1 to 4 but the location of the solid-state microrefrigerator 103 on the thermal conduction path between the sample attachment and the operating fluid 102 held by the vessel 101 is again slightly different. In fig. 5, the solid-state microrefrigerator 103 is located between the support structure 105 and the operating fluid 102 held in the vessel 101. Heat from the sample 104 is conducted to the support structure 105, from which it becomes absorbed to the cold end of the solid-state microrefrigerator 103, transferred through the solid-state microrefrigerator 103 and released from its hot end to the operating fluid 102.

In fig. 5, the solid-state microrefrigerator 103 may constitute a part of the solid structure of the vessel 101 that encloses the space for the operating fluid 102 and keeps the operating fluid 102 inside the vessel 101. Simultaneously, it may form at least a part of the attachment of the vessel 101 to the support structure 105. From the heat conduction point of view, it bridges the other mechanical structure of the vessel 101 by transferring heat directly between the support structure 105 and the operating fluid 102.

In fig. 6, the solid-state microrefrigerator 103 is located between the sample 104 and the operating fluid 102. It is capable of transferring heat directly from the sample 104 to the operating fluid 102, bridging both the support structure 105 and the structure of the vessel 101. Heat from the sample 104 becomes absorbed to the cold end of the solid-state microrefrigerator 103, transferred through the solid-state microrefrigerator 103 and released from its hot end to the operating fluid 102.

Mechanically, in fig. 6, the solid-state microrefrigerator 103 may form a part of the support structure 105 and/or a part of the structure of the vessel 101. Alternatively, the support structure 105 - if one is used even in the first place - could again be at the side(s) or top of the vessel 101, so that in the mechanical sense the solid-state microrefrigerator 103 would not need to go through any part of the support structure 105. If the solid-state microrefrigerator 103 forms part of the mechanical structure (i.e. walls) of the vessel 101, it (and its attachment to the other parts of the vessel structure) must exhibit sufficient tightness to prevent the operating fluid 102 from leaking out of the vessel 101.

A feature common to all embodiments described here is the order of cooling mechanisms. The aim of cooling a sample in a cryostat is to get the sample cold, so the cooling mechanism closest to the sample - in the sense of the paths for transferring heat - should be the one that achieves the lowest temperatures. In the embodiments described here, the solid-state microrefrigerator is there to achieve lower temperatures than the vessel that holds the operating fluid. Consequently, the vessel configured to hold the operating fluid does not need to be designed to achieve as low temperatures as the (cold head of the) solid-state microrefrigerator.

This, in turn, can be considered together with the fact that the cooling power achievable with dilution refrigerators for example scales in the second to fourth power of temperature. On the other hand, the cooling power of many solid-state microrefrigerator types scales only according to about T^{1.5}. If the aim is to cool the sample to, say, 10 mK but a solid-state microrefrigerator is responsible for the last cooling step from, say, 100 mK to 10 mK, the dilution refrigerator does not need to go colder than 100 mK. The cooling power of the dilution refrigerator is much higher at 100 mK than at 10 mK, which means that - as long as the solid-state microrefrigerator is powerful enough - the system can deal with a much larger heat load at the sample than a prior art system in which the dilution refrigerator had to reach 10 mK. The physics of the dilution refrigeration phenomenon dictate that the mixing chamber must be colder than about 600 mK during operation, but due to the principle explained herein, it does not need to reach temperatures in the range of only some millikelvins or some dozens of millikelvins. Operating a cryogenic cooling apparatus of this kind, equipped with a dilution refrigerator, may comprise operating the dilution refrigerator at a level that makes a temperature of its mixing chamber to be less than 600 mK but more than 50 mK.

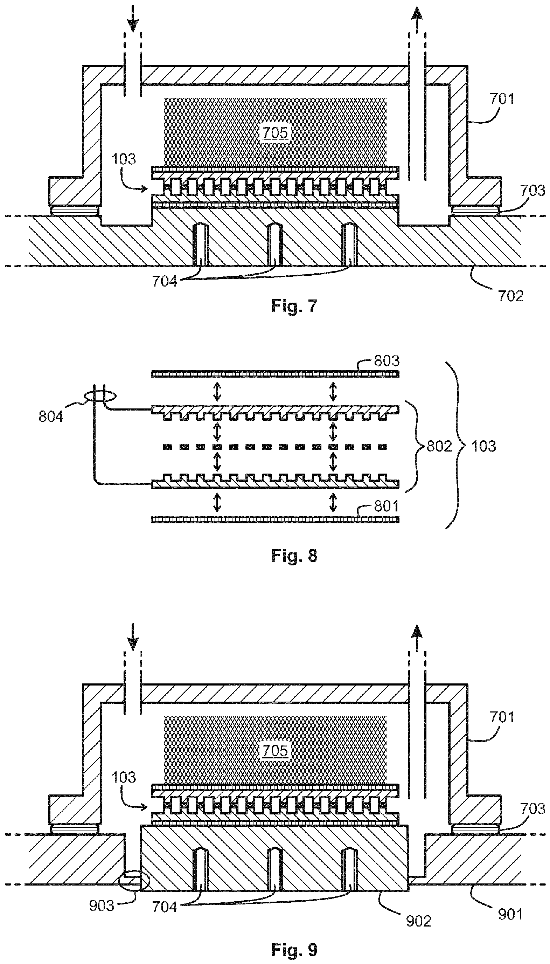

Fig. 7 illustrates parts of a cryogenic cooling apparatus in a cross-section. Here it is assumed that the vessel referred to above in the description of figs. 1 to 6 is the mixing chamber of a dilution refrigerator. Directions in which a helium mixture may flow into and out of the vessel are shown with arrows at the top of fig. 7.

In the embodiment of fig. 7, the vessel comprises a cover part 701 attached to a base part 702 with a sealed attachment. A seal 703 is schematically shown between the edge of the cover part 701 and a corresponding recipient surface of the base part 702. As illustrated by the dashed lines continuing outwards, the base part 702 may simultaneously constitute a cold flange of a cryostat, but this is not an essential requirement. In the sense of figs. 1 to 6, the base part 702 of fig. 7 may be considered to constitute (at least a part of) a support structure for the vessel. Alternatively, as it also delimits the space in which operating fluid will be held, the base part 702 may be considered to constitute a part of the mixing chamber structure.

The cryogenic cooling apparatus of fig. 7 comprises a sample attachment, which in this example embodiment appears as three threaded holes marked with the reference designator 704 in the lower surface of the base part 702. A sample may thus be bolted onto the lower surface of the base part 702. This way of attaching a sample is only an example, as there are other possibilities that could be used in place of or in addition to threaded holes. Examples of such other possibilities include, but are not limited to, one or more threaded extrusions as well as clamps configured to press the sample against the base part or other support.

The solid-state microrefrigerator 103 is placed in accordance with the principle of fig. 3 or fig. 5 above, depending on whether one considers the base part 702 to be a part of the vessel structure or a part of the support structure. Thermally, it is located on a thermal conduction path between the sample attachment 704 and the operating fluid that will be held in the sealed cavity limited by the cover part 701 and the base part 702. Similar to figs. 1 to 6, the heat receiving end (cold end) of the solid-state microrefrigerator 103 is its lower end in fig. 7, i.e. the end that is attached to the base part 702. The heat receiving end of the solid-state microrefrigerator 103 is thus towards a sample that will be attached to the sample attachment 704. The heat releasing end (hot end) of the solid-state microrefrigerator 103 is its upper end in fig. 7.

Mechanically, the solid-state microrefrigerator 103 is located inside the vessel or space limited by the cover part 701 and the base part 702 in the embodiment shown in fig. 7.

A thermal interface enhancer 705 is attached to the heat releasing end of the solid-state microrefrigerator 103. The purpose of the thermal interface enhancer 705, if used, is to improve the thermal coupling between the hot end of the solid-state microrefrigerator 103 and whatever it is thermally coupled to. In the embodiment of fig. 7, it is thermally coupled to the operating fluid held in the mixing chamber during operation. In such a case, the thermal interface enhancer 705 may comprise e.g. thermally conductive material in sintered form. Additionally or alternatively, the thermal interface enhancer 705 could comprise an array of thermally conductive posts protruding out of the heat releasing end of the solid-state microrefrigerator 103. Such thermally conductive posts may be manufactured by electroplating, for example. Additionally or alternatively, the thermal interface enhancer 705 could comprise solid material rendered into its final form in an additive manufacturing process, such material having a surface-to-volume ratio of at least 10⁵ 1/m. In the last-mentioned case, the material may comprise a plurality of extended thermal conduction paths in the form of regularly shaped portions of said solid material that extend through a majority of a thickness of the material and occur in a repetitive pattern throughout a layer of said material.

Fig. 8 is an exploded cross-sectional view of the most important layers of one possible type of a solid-state microrefrigerator 103. The solid-state microrefrigerator 103 meant here is a NIS refrigerator or SINIS refrigerator. It comprises certain layers in the following order from the heat receiving end to the heat releasing end: a first contact layer 801, a layer 802 of normal metal - insulator - superconductor tunnel junctions or superconductor - insulator - normal metal - insulator - superconductor tunnel junctions, and a second contact layer 803. Bias voltage couplings 804 are connected to the upper and lower halves of the layer 802 of normal metal - insulator - superconductor tunnel junctions or superconductor - insulator - normal metal - insulator - superconductor tunnel junctions. The geometrical form of said layer 802 may comprise constrictions that optimize performance against unwanted phonon-carried thermal leakage in the reverse direction.

In the embodiment of fig. 7, the layer that appears as the first contact layer 801 in fig. 8 connects the NIS refrigerator or SINIS refrigerator 103 to the base part 702. The layer that appears as the second contact layer 803 in fig. 8 connects the NIS refrigerator or SINIS refrigerator 103 to the thermal interface enhancer 705. The first and second contact layers 801 and 803 may comprise, for example, some material that is thermally conductive but electrically insulating, like aluminium oxide. Electrical insulation by the first and second contact layers 801 and 803 is not mandatory, but it may help to optimize the performance of the solid-state microrefrigerator and to protect it electrically. The routing of the bias voltage couplings is not shown in fig. 7 for reasons of graphical clarity, as the exact way of routing the bias voltage couplings is not important for the present description.

Fig. 9 illustrates parts of a cryogenic cooling apparatus in a cross-section. Also here it is assumed that the vessel referred to above in the description of figs. 1 to 6 is the mixing chamber of a dilution refrigerator. Also in the embodiment of fig. 9, the vessel comprises a cover part 701 attached to a base part. However, while in the embodiment of fig. 7 the base part (702) was an integral entity between the sealed attachment (703) and the sample attachment (704), in the embodiment of fig. 9 it is not. In fig. 9, the base part comprises a first portion 901 of a first material and a second portion 902 of a second, different material. The first and second portions 901 and 902 are fixedly attached together at the location marked with reference designator 903. The first portion 901 is involved in the sealed attachment 703 with the cover part 701. The second portion 902 is involved in the sample attachment 704. In the example embodiment shown in fig. 9, the sample attachment 704 comprises threaded holes in that surface of the second portion 902 that is accessible from outside the vessel that is to hold the operating fluid.

The reason for making the first and second portions 901 and 902 of different materials is related to optimizing their properties for the purpose for which they are used. The first portion 901 may be, for example, of the same material as the cover part 701. This would involve at least the advantage that, during cooling, the sealed attachment 703 would experience less mechanical stress than if the cover part 701 and the first portion 901 were made of different materials with different coefficients of thermal expansion. The first material may be stainless steel, for example.

The second material, i.e. the material of the second portion 902, may have a higher thermal conductivity at sub-Kelvin temperatures than the first material. This would involve at least the advantage that the second portion 902 would constitute an effective thermal link between a sample attached to the sample attachment 704 and the cold end of the solid-state microrefrigerator 103. The second material may be a brand of copper particularly suited for cryogenic applications, for example.

The fixed attachment 903 between the first and second portions 901 and 902 can be made with any suitable method that is sturdy enough for fixedly attaching together two solid pieces of different materials in cryogenic applications. An example of a suitable way of attaching is brazing. In any case, it is advantageous to make the attachment 903 so that the thermal conductivity between the first and second portions 901 and 902 is low. One way to achieve such an aim is to ensure that the cross-sectional area of the attachment is small. In the embodiment of fig. 9, the edge of the opening in the first portion 901 is much thinner than the bulk of the first portion for this reason: it offers only a relatively small surface area for making contact with the second portion 902.

As illustrated by the dashed lines continuing outwards, the first portion 901 may simultaneously constitute a cold flange of a cryostat, but this is not an essential requirement.

Similar to the embodiment of fig. 7, in the embodiment of fig. 9 the solid-state microrefrigerator 103 is inside the vessel in a space limited by the cover part 701 and the base part. Also similar to the embodiment of fig. 9, there is a thermal interface enhancer 705 attached to the heat releasing end of the solid-state microrefrigerator 103.

At first sight, the operating fluid held in the space delimited by the cover part and base part would thermally short-circuit the solid-state microrefrigerator 103 in the embodiments of figs. 7 and 9. In other words, the operating fluid (which will be at essentially the same temperature throughout) is in touch with both the hot end (upper end) of the solid-state microrefrigerator 103 and at least the edges of its cold end (lower end), as well as the solid part (base part 702 in fig. 7; second portion 902 in fig. 9) that is to convey heat from the sample to the cold end of the solid-state microrefrigerator 103.

However, one should note at least the relative surface areas. The cross-sectional area available for exchanging heat between the hot end of the solid-state microrefrigerator 103 and the operating fluid would be much larger than that available for exchanging heat between the cold end of the solid-state microrefrigerator 103 and the operating fluid, even without any thermal interface enhancers. Second, the effect of the thermal interface enchancer 705 is to reduce the Kapitza resistance between the hot end (upper end) of the solid-state microrefrigerator 103 and the operating fluid. With a sinter block, a 3D-printed maze structure, or the like as a thermal interface enhancer, this effect may be significant enough to essentially mitigate any effects of the (much weaker) thermal coupling between the operating fluid and the cold end of the solid-state microrefrigerator 103.

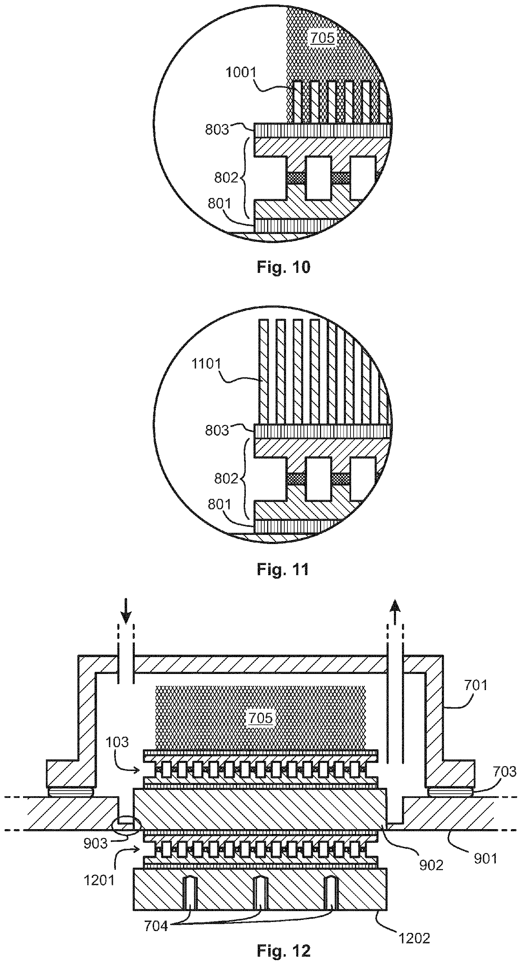

Figs. 10 and 11 are partial enlargements that show examples of thermal interface enhancer structures. In both fig. 10 and fig. 11, at the bottom are seen the layers 801, 802, and 803 of a solid-state microrefrigerator. In fig. 10, the thermal interface enhancer comprises an array of thermally conductive posts 1001 protruding out of the hot end (heat releasing end) of the solid-state microrefrigerator. These thermally conductive posts 1001 are embedded in a sinter block 705. In fig. 11, the thermal interface enhancer comprises also an array of thermally conductive posts 1101 protruding out of the hot end (heat releasing end) of the solid-state microrefrigerator, but these are longer than the posts 1001 in fig. 10 and effective to reduce the Kapitza resistance sufficiently without needing an additional sinter.

Fig. 12 illustrates parts of a cryogenic cooling apparatus in a cross-section. Also here it is assumed that the vessel referred to above in the description of figs. 1 to 6 is the mixing chamber of a dilution refrigerator. Similar to the embodiment of fig. 9, the base part that forms the lower part of the vessel comprises a first portion 901 and a second portion 902. A first solid-state microrefrigerator 103 is inside the vessel in a space limited by the cover part 701 and the base part. The sealed attachment 703 and the fixed attachment 903 may be similar to those marked with the same reference designators above, as may the materials of the cover part 701, first portion 901, and second portion 902. However, there is a second solid-state microrefrigerator 1201 attached by its hot end to the lower side of the second portion 902. A further portion 1202 with a sample attachment 704 is attached to the cold end of the second solid-state microrefrigerator 1201.

Fig. 12 is an example of cascaded solid-state microrefrigerators; i.e. such where the cold end of one solid-state microrefrigerator 103 is arranged to absorb heat from the hot end of another solid-state microrefrigerator 1201. In addition to (or in place of) cascaded arrangements it is possible to place two or more solid-state microrefrigerators in parallel at any part of a cryogenic cooling apparatus that is otherwise con-formant with the disclosure herein. For example, as essential parts of NIS-, SINIS-, and SmS-refrigerators are often manufactured in wafers not unlike those used to manufacture integrated circuits, the available wafer size may limit the size of a solid-state microrefrigerator that can be built. In such a case one may use two or more solid-state microrefrigerators in parallel in place of any of the individual solid-state microrefrigerators described above.

It is obvious to a person skilled in the art that with the advancement of technology, the basic idea of the invention may be implemented in various ways. The invention and its embodiments are thus not limited to the examples described above, instead they may vary within the scope of the claims.

## Claims

1. A cryogenic cooling apparatus, comprising:
- a vessel (101) configured to hold operating fluid (102) during operation, and
- at least one solid-state microrefrigerator (103) with a heat receiving end and a heat releasing end; **characterized in that**
- the cryogenic cooling apparatus comprises a sample attachment (704) configured to receive a sample (104) into mechanical and thermal connection for cooling said sample during operation of the cryogenic cooling apparatus, and
- said at least one solid-state microrefrigerator (103) is located on a thermal conduction path between said sample attachment and operating fluid (102) held by said vessel (101), with said heat receiving end towards said sample (104) and said heat releasing end towards said operating fluid (102).

2. A cryogenic cooling apparatus according to claim 1, wherein said vessel comprises a cover part (701) attached to a base part (702, 901, 902) with a sealed attachment (703).

3. A cryogenic cooling apparatus according to claim 2, wherein at least one of said at least one solid-state microrefrigerators (103) is inside said vessel (101) in a space limited by said cover part (701) and said base part (702).

4. A cryogenic cooling apparatus according to claim 2 or 3, wherein:
- said base part (702) is an integral entity between said sealed attachment (703) and said sample attachment (704).

5. A cryogenic cooling apparatus according to claim 2 or 3, wherein:
- said base part comprises at least a first portion (901) of a first material and a second portion (902) of a second, different material, said first and second portions (901, 902) being fixedly attached together,
- said first portion (901) is involved in said sealed attachment (703), and
- said second portion (902) is involved in said sample attachment (704).

6. A cryogenic cooling apparatus according to claim 5, wherein:
- said first portion (901) is of a same material as said cover part (701), and
- said second material has a higher thermal conductivity at sub-Kelvin temperatures than said first material.

7. A cryogenic cooling apparatus according to any of claims 3 to 6, comprising a thermal interface enhancer (705, 1001, 1101) attached to said heat releasing end of the solid-state microrefrigerator.

8. A cryogenic cooling apparatus according to claim 7, wherein said thermal interface enhancer comprises thermally conductive material in sintered form (705) .

9. A cryogenic cooling apparatus according to any of claims 7 or 8, wherein said thermal interface enhancer comprises an array of thermally conductive posts (1001, 1101) protruding out of said heat releasing end of the solid-state microrefrigerator.

10. A cryogenic cooling apparatus according to any of the preceding claims, wherein among said at least one solid-state microrefrigerators is at least one NIS refrigerator or SINIS refrigerator that comprises, in the following order from said heat receiving end to said heat releasing end,
- a first contact layer (801),
- a layer (802) of normal metal - insulator - superconductor tunnel junctions or superconductor - insulator - normal metal - insulator - superconductor tunnel junctions, and
- a second contact layer (803).

11. A cryogenic cooling apparatus according to any of the preceding claims, wherein:
- the cryogenic cooling apparatus comprises a dilution refrigerator, and
- said vessel (101) is a mixing chamber of said dilution refrigerator.

12. A method for cryogenically cooling a sample, comprising:
- providing cooled operating fluid in a vessel,
- using at least one solid-state microrefrigerator (103) to absorb heat from said sample into a cold end of the solid-state microrefrigerator (103, 1201), and
- releasing heat from a hot end of said solid-state microrefrigerator (103, 1201) towards said operating fluid.

13. A method according to claim 12, wherein said releasing of heat from said hot end of said solid-state microrefrigerator (103) towards said operating fluid comprises releasing said heat from said hot end of said solid-state microrefrigerator (103) directly to said operating fluid.

14. A method according to claim 12, wherein said releasing of heat from said hot end of said solid-state microrefrigerator (1201) towards said operating fluid comprises releasing said heat from said hot end of said solid-state microrefrigerator (1201) to a cold end of a further solid-state microrefrigerator (103).

15. A method according to any of claims 12 to 14, wherein said providing of cooled operating fluid in a vessel comprises circulating helium mixture into a mixing chamber of a dilution refrigerator, and the method comprises operating said dilution refrigerator at a level that makes a temperature of said mixing chamber to be less than 600 mK but more than 50 mK.
